Europäisches Patentamt

European Patent Office

Office européen des brevets

(19)

(11) Numéro de publication : **0 307 433 B1**

# (12) FASCICULE DE BREVET EUROPEEN

(45) Date de publication du fascicule du brevet :
29.07.92 Bulletin 92/31

(51) Int. Cl.⁵ : **G01R 33/50**

(21) Numéro de dépôt : **88902503.7**

(22) Date de dépôt : **15.03.88**

(86) Numéro de dépôt international :
**PCT/FR88/00136**

(87) Numéro de publication internationale :
**WO 88/07672 06.10.88 Gazette 88/22**

(54) PROCEDE D'IMAGERIE RAPIDE PAR RESONANCE MAGNETIQUE NUCLEAIRE.

(30) Priorité : **25.03.87 FR 8704132**

(43) Date de publication de la demande :
**22.03.89 Bulletin 89/12**

(45) Mention de la délivrance du brevet :
**29.07.92 Bulletin 92/31**

(84) Etats contractants désignés :
**DE GB IT NL**

(56) Documents cités :
**EP-A- 0 135 847**

(56) Documents cités :
**IEEE Transactions on Nuclear Science, vol.
NS-33, no.1, February 1986, (New York, US),
T.C. Mills et al.: "Investigation ofpartial flip
angle magnetic resonance imaging", pp
496-500 see chapters "NMR Intensity Model"
and "Discussion"**

(73) Titulaire : **GENERAL ELECTRIC CGR S.A.
100, rue Camille-Desmoulins
F-92130 Issy les Moulineaux (FR)**

(72) Inventeur : **LE ROUX, Patrick
2, résidence les Quinconces
F-91190 Gif-sur-Yvette (FR)**

(74) Mandataire : **Schmit, Christian Norbert Marie
et al
Cabinet Ballot-Schmit 7, rue Le Sueur
F-75116 Paris (FR)**

EP 0 307 433 B1

**Description**

La présente invention a pour objet un procédé d'imagerie rapide d'une partie d'un corps soumis à un champ magnétique intense dit orientateur au cours d'une expérimenttion de résonance magnétique nucléaire (RMN). Ce type d'expérimentation rencontre un succès croissant actuellement dans le domaine médical où les images produites servent d'aide au diagnostic, en particulier au diagnostic du cancer. L'application du procédé selon l'invention n'est cependant pas cantonnée à ce domaine, ce procédé peut en effet être également mis en oeuvre, par exemple, dans le domaine des mesures physiques où on utilise aussi des spectromètres.

Pour obtenir une image d'une tranche d'un corps à examiner, on soumet le corps en question, et en particulier la partie dans laquelle se trouve la tranche, à un champ magnétique continu, intense, et homogène. Sous l'effet de ce champ les moments magnétiques des particules du corps, s'orientent au bout de quelques instants (en quelques secondes), dans la direction du champ magnétique : d'où le nom de champ orientateur donné à ce champ. Si on excite alors les moments magnétiques des particules du corps avec une excitation magnétique radiofréquence oscillant à une fréquence convenable, on provoque le basculement de l'orientation des moments magnétiques excités. A la fin de l'excitation ces moments magnétiques tendent à se réaligner avec le champ orientateur en un mouvement de précession naturel dit mouvement de précession libre. Au cours de ce mouvement de précession les particules rayonnent une énergie électromagnétique de désexcitation que l'on peut mesurer. La fréquence du signal de désexcitation dit aussi de RMN est caractéristique des particules excitées (dans le domaine médical il s'agit de l'atome d'hydrogène contenu dans les molécules d'eau disséminées partout dans le corps humain) et de la force du champ orientateur. Du traitement du signal mesuré on en déduit les caractéristiques du corps.

Le traitement du signal mesuré pour extraire une image se complique du fait que toutes les particules du corps, dans toute la région excitée, réemettent un signal de désexcitation à l'issue de l'excitation. Il importe donc de discriminer les contributions dans le signal de RMN global de toutes les régions élémentaires (appelées voxels) du volume excité pour reconstruire leur répartition, en définitive pour élaborer l'image. Cette discrimination n'est possible qu'en effectuant une série de séquences d'excitation - mesure au cours de chacune desquelles on code, différemment d'une séquence à l'autre, les signaux de RMN à mesurer. Connaissant le codage appliqué on sait par des techniques d'imagerie pure reconstruire l'image.

La mesure du signal de RMN concerne en fait l'amplitude de ce signal. En effet compte tenu d'une fréquence de démodulation autour de laquelle on examine le signal de RMN , on ne peut espérer comme résultat de mesure qu'une mesure de la densité, dans les structures étudiées, des particules spécifiques (l'hydrogène) dont on n'étudie alors qu'une des fréquences de résonance. Grossièrement, au bout d'une durée donnée après l'excitation le signal de RMN est d'autant plus fort que cette densité est forte. En fait, cette densité n'agit pas que sur l'amplitude originelle du signal de RMN. Dans la pratique, en médecine, on suppose même que toutes les régions des corps ont, de ce point de vue, une même contribution au signal de RMN. Par contre la densité agit assez fortement sur l'amortissement, la relaxation, de ce signal de RMN. Cet amortissement est un amortissement complexe : il est représentatif d'une interaction dite spin-réseau des particules (le proton de l'atome d'hydrogène) excitées avec la matière environnante et d'une interaction dite spin-spin des protons entre eux. Dans une modélisation connue des phénomènes physiques qui interviennent on a pu déterminer que le temps de relaxation spin-réseau, dit aussi temps $T_1$, correspond à la constante de temps d'une repousse (d'une réorientation) exponentielle de la composante, alignée avec le champ orientateur (on dit aussi longitudinale), du moment magnétique global en un endroit concerné du corps. Le temps de relaxation spin - spin, dit $T_2$, correspond également à une constante de temps, mais içi d'une décroissance exponentielle de la composante transverse ( orthogonale à la composante longitudinale) de ces moments magnétiques. Dans un exemple qui sera évoqué plus loin dans le cadre de la description de l'invention, on fera état d'un temps $T_1$ de l'ordre de 500 ms et d'un temps $T_2$ de l'ordre de 100 ms : les régions concernées du corps seront principalement la tête et plus particulièrement le cerveau.

Il est possible au cours de séries d'expérimentations de types différents de faire apparaître un phénomène de relaxation de préférence à l'autre. On dit alors que l'on fait des images en $T_1$ ou en $T_2$ selon les cas. Le paramètre essentiel des expérimentations RMN sur lequel on joue dans ces cas est alors le temps de répétition $T_R$ qui ponctue la périodicité des séquences de la série des séquences d'imagerie mises en oeuvre. En simplifiant, si ce temps est de l'ordre du temps $T_1$ moyen des particules situées dans les parties incriminées du corps, on peut montrer, pour deux régions de ce corps où règnent des concentrations de particules telles que les temps de relaxation $T'_1$ et $T''_1$ relatifs à ces régions ont des valeurs situées de part et d'autre de la valeur $T_R = T_1$ moyen choisie, que les contributions relatives à ces régions et apportées dans le signal de RMN global sont différenciées au maximum : la différence d'amplitude est la meilleure. Par traitement il est alors possible de tracer précisément les contours des régions à $T'_1$ et des régions à $T''_1$. Malheureusement

cette différenciation de l'image en $T_1$ n'est pas toujours suffisamment pertinente pour discriminer des régions saines (par exemple à $T'_1$) des régions malades, atteintes du cancer (par exemple à $T''_1$), car celles-ci possèdent justement des $T_1$ semblables entre eux.

On sait, si l'image en $T_1$ n'est pas suffisamment explicite, qu'on peut avoir recours à l'image en $T_2$ dont les caractérisitiques de différenciation peuvent être différentes. En particulier on sait que dans le cerveau humain la matière grise, la matière blanche, et encore plus les tumeurs, possèdent des réponses en $T_2$ bien différenciées. Dans la pratique le signal de RMN mesuré n'est jamais qu'un signal correspondant à la composante orthogonale au champ orientateur du mouvement de précession des moments magnétiques basculés. Or on s'ait, si le temps de répétition est de l'ordre du $T_1$ moyen, que l'amplitude de ce signal est directement représentative des contributions en $T_1$ des différentes parties du corps. Pour faire une image en $T_2$, il est nécessaire d'attendre une repousse totale de l'aimantation (de sa composante longitudinale) : il faut attendre entre chaque séquence une durée qui avoisine environ 3 ou 4 fois la durée de $T_1$. Au bout de cette durée, à la concentration près des particules (ce qu'on néglige), on peut dire que le premier signal de RMN mesuré n'est dépendant que du temps de relaxation $T_2$. C'est seulement si le taux de répétition est trop rapide que l'influence de la décroissance en $T_2$ du signal de RMN s'efface devant l'importance de la différenciation des repousses en $T_1$. A ce stade de l'explication on voit immédiatement poindre une des difficultés des images en $T_2$ : elles sont longues. En pratique elles sont de l'ordre de 3 ou 4 fois plus longues que les images en $T_1$. Par exemple pour une image en $T_2$ d'une coupe de la tête, un patient doit être soumis à l'expérimentation, sans bouger, pendant une durée de 17 mn. Pour éviter que le patient ne bouge on est contraint de lui maintenir la tête dans un carcan ce qui rend l'expérimentation RMN, au demeurant inoffensive, très pénible.

L'invention a pour objet de 'remédier aux inconvénients cités en proposant une image en $T_2$ rapide, dans un exemple elle peut durer de l'ordre de 3 à 4 mn, tout en évitant les effets perturbateurs'du contraste en $T_1$ dans cette image. Dans l'invention on favorise la repousse de la composante longitudinale de l'aimantation, avec une excitation particulière, de telle façon que l'aimantation longitudinale puisse être considérée comme suffisante très vite, au point qu'on peut accélérer le rythme des séquences. Une telle solution est par exemple décrite dans un article I.E.E.E. Transactions on Nuclear Science, Vol. 33, n° 1 February 1986, intitulé "INVESTIGATION OF PARTIAL FLIP ANGLE MAGNETIC RESONANCE IMAGING" dû à Timothy C. MILLS et al. Dans l'invention on montre qu'on peut encore améliorer ces résultats.

Dans ce but l'invention concerne un procédé d'imagerie selon la revendication 1.

La présente invention sera mieux comprise à la lecture de la description qui suit et à l'examen des figures qui l'accompagnent. Celles-ci ne sont données qu'à titre indicatif et nullement limitatif de l'invention. Les figures montrent :
- figure 1 : une représentation schématique d'une machine de RMN pour la mise en oeuvre du procédé selon l'invention ;
- figure 2a à 2g : des diagrammes temporels de phénomènes physiques et de signaux intervenant dans une séquence du procédé de l'invention;
- figure 3a à 3d : des diagrammes temporels de comparaison entre des caractéristiques d'excitations selon l'invention;
- figure 4 : le diagramme temporel d'une variante du procédé de l'invention.

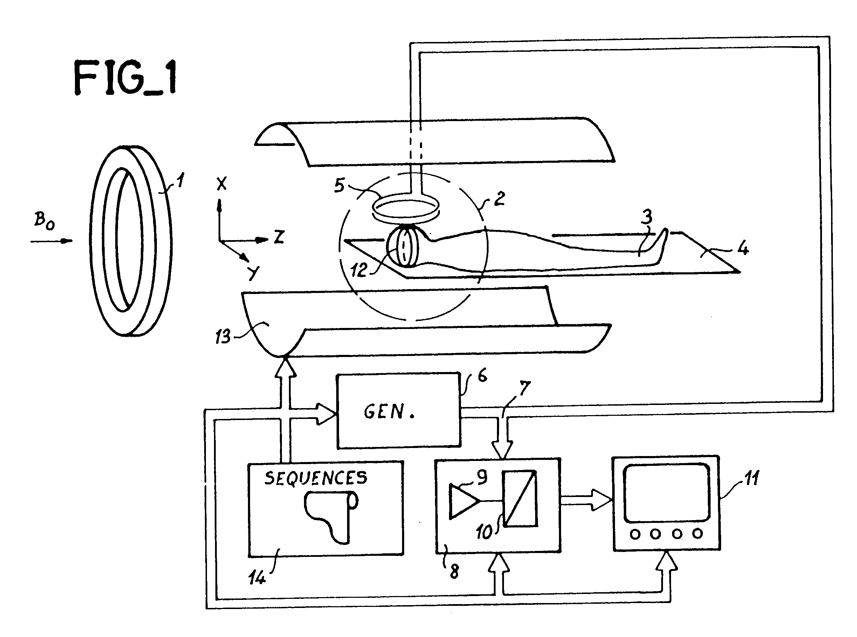

La figure 1 montre une machine de RMN pour la mise en oeuvre du procédé selon l'invention. Cette machine eLomporte, schématiquement, des moyens 1 pour produire unu champ magnétique $B_0$ intense, continu et homogène dans une région 2 d'examen. Un corps 3, supporté par exemple par un plateau 4 est approché de la région 2. Pendant toute l'expérimentation le corps reste soumis au champ magnétique $B_0$. Au moyen d'une antenne 5 reliée à un générateur 6 on peut provoquer l'excitation des moments magnétiques des particules du corps 3 situées dans la zone 2. Les excitations sont temporaires. A l'issue de ces excitations l'antenne 5 peut servir à prélever le signal de désexcitation pour le conduire, via un duplexeur 7, sur des moyens 8 de réception. Les moyens 8 comportent d'une manière classique des circuits 9 d'amplication et de démodulation, et des circuits 10 de traitement. Le traitement peut comporter la mise en forme du signal en vue de sa représentation sur un dispositif 11 de visualisation. On peut faire alors apparaitre sur l'écran du dispositif 11 l'image d'une tranche 12 du corps 3. Une expérimentation en vue d'obtenir une image comporte une pluralité de séquences excitation-mesure au cours de chacune desquelles on applique avec des bobines de gradient 13 des codages au signal de précession libre des moments magnétiques. Ces codages ainsi que le fonctionnement du générateur 6, du duplexeur 7 et des moyens de réception 8 et de visualisation 11 sont régis par un séquenceur 14 dont un programme organise les actions. Tous ces organes sont connus en eux mêmes. En particulier le séquenceur 14 possède la propriété de programmabilité de ses séquences. On peut ainsi modifier simplement, dans le programme, les caractérisitiques de chacune des opérations à effectuer dans les séquences pour changer la nature de l'expérimentation entreprise.

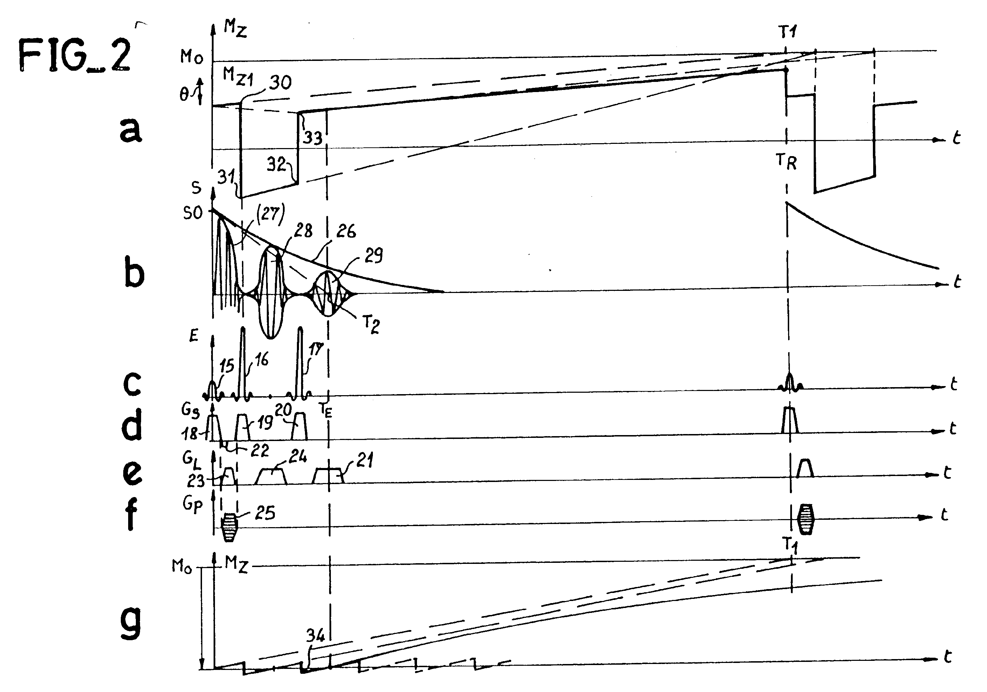

Les figures 2a à 2g représentent des diagrammes temporels de grandeurs physiques et de signaux intervenant dans le procédé de l'invention. En admettant, conventionellement, que le corps 3 est aligné selon une orientation Z colinéaire au champ $B_0$, les moments magnétiques des particules de ce corps s'orientent dans la direction Z. Ces particules possèdent donc une aimantation cotée $M_z$. La figure 2a représente l'allure de la modification de la valeur de la composante longitudinale de l'aimantation de chacune des particules du corps 3 dans la région 2 au moment d'une séquence de durée $T_R$. Les figures 2b à 2f montrent respectivement le signal de précession libre S (détecté par l'antenne 5), le signal d'excitation E avec les particularités de l'invention (appliqué par l'antenne 5), les impulsions de gradient de sélection $G_S$, de gradient de lecture $G_J$, et de gradient de codage de phase $G_P$ nécessaires pour la mise en oeuvre d'une méthode d'imagerie. Les impulsions de gradient représentées içi correspondent à une méthode d'imagerie connue sous le nom de 2DFT. Dans cette méthode, au cours de chaque séquence, on applique des impulsions d'excitation, içi 15 à 17, en présence d'impulsions de gradient dit de sélection respectivement 18 à 20. Ce faisant on cantonne la naissance du phénomène de RMN dans une tranche sélectionnée 12 perpendiculaire à un axe (Z) : l'axe de sélection. Lors de la réception du signal de désexcitation, on applique un gradient dit de lecture au moyen d'une impulsion 21 sur un axe perpendiculaire au précédent. Du fait de codages indésirables inhérents à cette méthode de codage, les impulsions de gradient 18 à 21 doivent être compensées par des impulsions de précodage 22 à 24, d'une manière connue. Au cours de chaque séquence, et de manière à particulariser chaque séquence, sur un troisième axe orthogonal aux deux autres on applique des impulsions de gradient de codage de phase 25. Sur la figure 2 f, l'impulsion 25 comporte plusieurs niveaux pour indiquer qu'elle évolue d'une séquence à l'autre.

Une particularité de l'invention réside dans la repousse de l'aimantation longitudinale des moments magnétiques. La figure 2g montre l'état de la technique relatif aux images en $T_2$. Immédiatement à la fin de l'excitation initiale, l'amplitude $S_0$ du signal de précession libre est directement liée au sinus de l'angle de basculement des moments magnétiques d'une part, et à la valeur $M_0$ de l'aimantation longitudinale avant excitation d'autre part. De manière à avoir un signal de précession libre le plus fort possible, $S_0$ le plus grand possible, on choisit naturellement une excitation dite à 90° (qui fait basculer de 90° l'orientation du moment magnétique des particules) et on attend suffisamment longtemps entre chaque séquence pour que cette aimantation longitudinal $M_z$ soit revenue à sa valeur maximale $M_0$. Comme $T_1$ est le temps de relaxation de l'aimantation longitudinale, on attend pratiquement trois à quatre fois $T_1$ avant de recommencer une séquence suivante. Il est intéressant de remarquer ce qu'il advient le cette aimantation longitudinale lorsque la séquence d'excitation utilisée comporte, après l'excitation à 90°, une ou plusieurs excitations à 180° dites d'écho de spin. En effet d'une manière connue le signal de RMN ne décroit pas, comme on s'y attend, exponentiellement comme l'indique la courbe 26 avec une constante de temps $T_2$. Mais il s'évanouit au contraire très rapidement (27) du fait des inhomogénéités locales du champ orientateur. Celles-ci ont pour effet de déphaser les contributions de chacune des parties de la tranche 12 au signal de RMN global. En appliquant alors, d'une manière connue, des impulsions d'écho de spin tels que 16 et 17 on provoque la renaissance, respectivement en 28 et 29, du signal de RMN.

En revenant à la figure 2g on peut constater quel est l'effet sur l'aimantation longitudinale $M_z$ de ces impulsions d'écho de spin. Entre l'linpulsion 15 et l'linpulsion 16 l'aimantation longitudinale croît exponentiellement avec une constante de temps $T_1$. Au moment de l'application de l'impulsion d'excitation 16 on peut considérer que cette aimantation est brutalement basculée de 180°, sa valeur devient symétrique de celle qu'elle avait juste avant cette excitation. Entre l'impulsion 16 et l'impulsion 17, l'aimantation longitudinale croît à nouveau exponentiellement, avec aussi une constante de temps $T_1$ jusqu'à l'impulsion 17 où elle subit le même sort. Ce phénomène se reproduit autant de fois qu'il y a, dans la séquence utilisée, d'impulsions d'écho de spin. Il est utile de remarquer que la renaissance en 28 ou en 29 du signal de RMN se produit sensiblement à une date où, du rait des retournements, la composante longitudinale du moment magnétique passe par 0.

La consultation de la figure 2a montre de ce point de vue l'effet immédiat de l'invention. Dans celle ci, au moment de l'excitation initiale les moments magnétiques ne sont basculés que d'une faible valeur cotée θ . En conséquence la composante longitudinale des moments magnétiques entame sa remontée jusqu'à la valeur $M_0$ à partir de cette valeur. Sa constante de temps de remontée est également $T_1$, caractéristique des particules excitées. Au moment de l'impulsion d'écho de spin 16, tout ce passe comme si la composante longitudinaire prenait une valeur symétrique 31 de sa valeur 30 avant l'application de l'impulsion 16. Pendant la durée qui sépare les impulsions 16 et 17, la composante longitudinale croît exponentiellement (là aussi avec une constante de temps $T_1$) vers la valeur $M_0$. Au moment de la deuxième impulsion d'excitation d'écho de spin 17 cette composante longitudinale est à nouveau renversée. Elle passe de la valeur 32 à la valeur 33. De l'instant qui sépare l'application de l'impulsion 17 jusqu'à celui où une nouvelle séquence est entreprise dans les mêmes conditions, la composante longitudinale $M_z$ évolue exponentiellement vers $M_0$.

L'avantage obtenu par le procédé de l'invention, faible basculement de l'aimantation, combiné avec une succession en nombre pair (içi 2) d'impulsions d'écho de spin, amène le moment magnétique longitudinal à croître depuis une valeur 33. Celle-ci, qui est déjà proche de la valeur $M_0$, est bien plus intéressante que la valeur correspondante 34, de laquelle part l'aimantation avec l'excitation initiale classique à 90°. Sur le plan pratique au bout d'un temps $T_R$ de l'ordre du $T_1$ moyen des particules excitées, on peut admettre que l'aimantation $M_z$ a atteint une valeur suffisante pour réentamer une séquence suivante. Alors que cette valeur aurait été notablement insuffisante auparavant. Sur la figure 2a la valeur de départ $M_z$ de la composante longitudinale du moment magnétique n'est pas égale à $M_0$ du fait de la succession rapide des séquences. Alors qu'au cours d'une toute première séquence d'excitation-mesure la valeur $M_z$ part de $M_0$, au bout de quelques séquences, la valeur de départ s'est amortie, stabilisée, à une valeur $M_{z1}$ dont l'écart à la valeur $M_0$ dépend en définitive de la valeur $\theta$ utilisée dans l'expérimentation. En pratique il suffit d'attendre une dizaine de séquences "à blanc" avant de commencer les séquences utilisables directement pour composer l'image.

La figure 2b comporte encore une indication. De préférence le signal utilisé pour faire l'image sera le signal de RMN 29 bien que le signal 28 présente une valeur d'amplitude supérieure au signal 29. En effet, d'une manière préférée on s'arrange pour que le temps total d'écho $T_E$ soit de l'ordre des temps de relaxation $T_2$ des différentes parties à diférencier dans l'image. Aussi, si le signal 29 est moins fort que le signal 28, il est par contre plus contrasté en $T_2$, que le signal 28. On peut faire des meilleures images avec le signal 29 qu'avec le signal 28 même si ces dernières images sont quelque peu bruitées.

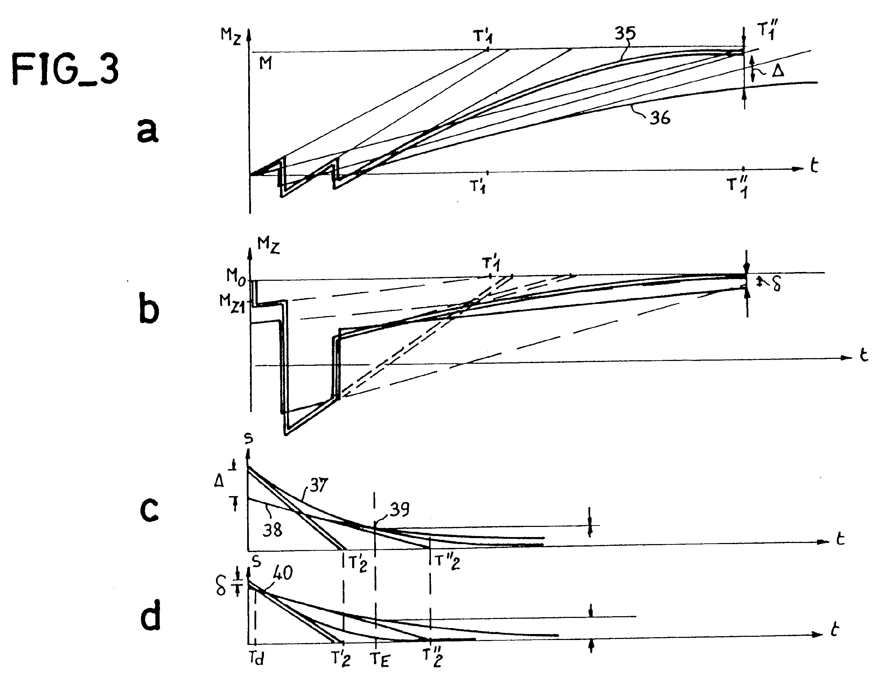

Les figures 3a à 3d montrent des phénomènes de différenciation et de contraste pour deux types de tissus contenus dans une région explorée, et dont les temps de relaxation $T'_1$ et $T''_1$ ainsi que $T'_2$ et $T''_2$ sont cotés sur les figures. Le but de ces figures est de montrer que le choix d'un grand angle de basculement (figure 3a et 3c) est moins favorable pour le contraste en $T_2$ que le choix d'un faible angle de basculement. Sur la figure 3a, qui rappelle la figure 2g on a fait figurer l'évolution des signaux de RMN 35 (en double trait) de tissus dont le temps de relaxation $T'_1$ est faible, et 36 dont le temps de relaxation $T''_1$ est plus fort : en exagérant on a même pris le double. A la fin de la séquence, les aimantations longitudinales des particules des tissus d'un type et de l'autre contribuent, à densité égale, au signal de RMN avec des amplitudes dont la différence vaut $\Delta$. Cette différence de l'aimantation longitudinale retentit, figure 3c, sur le signal de RMN détectable avec un écart proportionnel à $\Delta$. Malheureusement, le tissu qui a le plus faible temps de relaxation $T_1$ a également le plus faible temps de relaxation $T_2$. Il en résulte que la contribution 37 au signal de RMN global de ce premier tissu décroît plus vite dans le temps que la contribution 38 au signal de RMN de l'autre tissu. Comme la contribution de cet autre avait au départ une valeur plus basse, ces deux signaux évoluent vers une valeur commune 39 où il est impossible de les distinguer : la différenciation en $T_2$ est alors inopérante. Il est connu que ce signal commun 39 se présente à une date sensiblement intermédiaire entre les dates correspondant aux constantes de temps $T'_2$ et $T''_2$ relative à ces tissus. Autrement dit la mesure du signal 29 (figure 2b) intervient justement à un instant où il n'y a plus de contraste en $T_2$.

Par contre figure 3b et 3d, le basculement est faible. Du fait de sa constante de temps $T_1$ plus forte, l'aimantation du deuxième tissu ne remonte pas jusqu'à l'aimantation $M_0$ initiale, elle ne remonte, à la fin de chaque séquence, que jusqu'à une valeur $M_{z1}$. Par contre le premier tissu, à constante de temps $T'_1$ faible, revient par exemple à la valeur $M_0$. L'écart entre ces aimantations est cependant faible : il a une valeur $\delta$. Cet écart faible retentit néanmoins dans le signal de RMN mesurable après l'excitation. Mais cet écart faible a pour effet de "déplacer" la valeur commune, de la valeur 39 à la valeur 40. Cette valeur commune est atteinte à une date $T_d$ située maintenant hors des instants où le signal de RMN est mesuré. Il en résulte qu'au moment de la lecture autour d'une date $T_E$ la différence des contributions au signal de RMN global est maximum : l'image en $T_2$ est bien contrastée.

Sur le plan pratique un compromis doit être trouvé sur la valeur de $\theta$. En effet si $\theta$ est trop grand, le contraste en $T_1$ annihile le contraste en $T_2$. Par contre si $\theta$ est trop faible, par exemple de l'ordre de seulement quelques degrés, le signal $S_0$ (figure 2b) est trop faible. Autrement dit dans le premier cas on n'aura pas assez de contraste, et dans le deuxième on aura trop de bruit. Expérimentalement on a découvert, et on peut le vérifier théoriquement, que des résultats appréciables sont obtenus quand l'angle de basculement vaut entre 30 et 60 degrés. D'une manière préférée, il vaut entre 30 et 45 degrés.

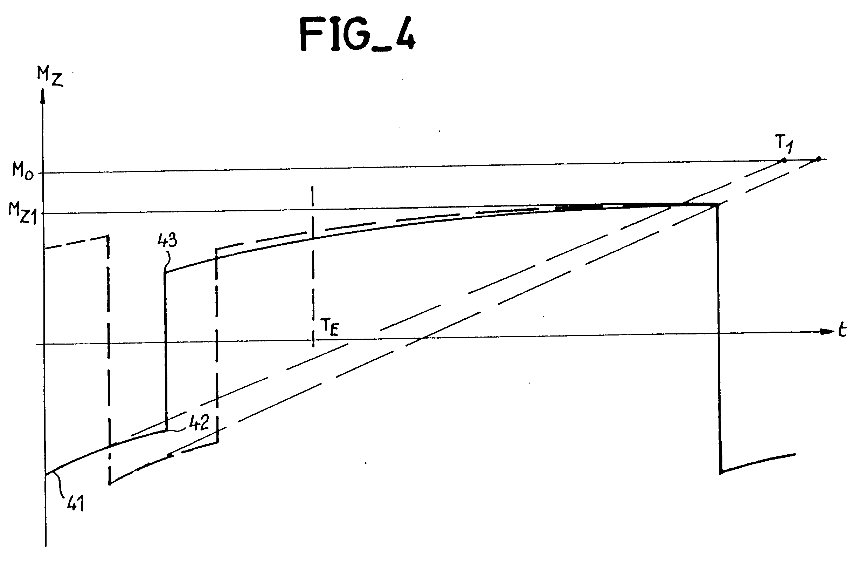

La figure 4 montre une variante d'excitation selon l'invention. Au lieu d'effectuer un basculement de faible amplitude lors de la première excitation 15 (figure 2c) on provoque au contraire un basculement très important de l'orientation des moments magnétiques. Ce basculement tout en étant important est cependant inférieur à 180°. Par exemple il vaut 135°. Dans ces conditions l'aimantation longitudinale prend une valeur 41. Avec une telle excitation de forte amplitude il convient, pour restaurer l'aimantation, de n'utiliser qu'un nombre impair d'excitations d'écho de spin. D'une manière préférée on en prend même qu'une seule. Lors de cette unique excitation d'écho de spin l'aimantation passe d'une valeur 42 à une valeur 43. La mesure est effectuée au bout d'un temps d'écho $T_E$ comparable aux temps d'échos précédents. Tout revient à considérer, figure 2c, qu'on a effectué en même temps une excitation 15 et une excitation 16. Si on compare une séquence avec basculement faible et nombre pair d'impulsions d'écho de spin avec une séquence avec basculement important et nombre impair d'impulsions d'écho de spin, on se rend compte que la restauration de l'aimantation est mieux assurée dans la première solution. Le rappel en tirets de l'évolution de cette aimantation sur la figure 4 le montre.

Dans l'invention on limite donc les basculements de manière à obtenir un bon rapport signal à bruit en réponse. On peut montrer qu'avec une perte de rapport signal à bruit de seulement 3 db (sin 60° = 1/2) on obtient un rythme de production d'image quatre fois plus rapide. Avec un angle de basculement encore plus faible le rythme peut encore être augmenté. Le compromis à trouver dépend pour une grande partie du facteur de bruit de la chaine de réception> utilisée dans la machine de RMN.

## Revendications

1. Procédé d'imagerie rapide par résonance magnétique nucléaire d'un corps (3) soumis (1) à un champ magnétique (B_0) intense dit orientateur, du type comportant une pluralité des séquences aux cours desquelles :
 – on excite (15-17) les moments magnétiques des particules du corps au moyen d'une excitation électromagnétique radiofréquence pour faire basculer ($\theta$) l'orientation de ces moments magnétiques par rapport à la direction du champ orientateur,
 – on code (18-25) le signal de désexcitation résultant de cette excitation à l'aide d'impulsions de gradients (13) de champ magnétique,
 – on mesure (7-9) ce signal résultant codé,
 – et on traite (10-11), en le décodant, le signal mesuré pour en extraire une image d'une partie du corps,
 – l'excitation comportant des impulsions d'excitation pour favoriser la repousse des composantes, alignées avec le champ orientateur, des moments magnétiques des particules avant une séquence suivante ($T_R$),
 caractérisé en ce que
 – l'excitation comporte une impulsion (15) pour faire basculer les moments magnétiques d'un angle nettement inférieur à 90°, suivie d'un nombre pair d'impulsions d'excitation (16-17) à 180° du type dit à écho de spin.

2. Procédé selon la revendication 1, caractérisé en ce que le nombre pair vaut 2.

3. Procédé selon la revendication 1 ou 2, caractérisé en ce que l'angle de basculement vaut entre 30° et 60°.

4. Procédé selon la revendication 3, caractérisé en ce que l'angle de basculement vaut sensiblement 45°.

5. Procédé d'imagerie rapide par résonance magnétique nucléaire d'un corps (3) soumis (1) à un champ magnétique (BO) intense dit orientateur, du type comportant une pluralité des séquences aux cours desquelles :
 – on excite (15-17) les moments magnétiques des particules du corps au moyen d'une excitation électromagnétique radiofréquence pour faire basculer ($\theta$) l'orientation de ces moments magnétiques par rapport à la direction du champ orientateur,
 – on code (18-25) le signal de désexcitation résultant de cette excitation à l'aide d'impulsions de gradients (13) de champ magnétique,
 – on mesure (7-9) ce signal résultant codé,
 – et on traite (10-11), en le décodant, le signal mesuré pour en extraire une image d'une partie du corps,
 – l'excitation comportant des impulsions d'excitation pour favoriser la repousse des composantes, alignées avec le champ orientateur, des moments magnétiques des particules avant une séquence suivante ($T_R$),
 caractérisé en ce que
 – l'excitation comporte une impulsion pour faire basculer les moments magnétiques d'un angle nettement supérieur à 90°, suivi d'un nombre impair d'impulsions d'excitation à 180° du type dit à écho de spin.

6. Procédé selon la revendication 5, caractérisé en ce que le nombre impair vaut 1.

7. Procédé selon la revendication 5, caractérisé en ce que l'angle vaut 135°.

8. Procédé selon la revendication 1 ou la revendication 5, caractérisé en ce que la durée du temps d'écho total ($T_E$), défini par les dates d'application des impulsions d'écho de spin est de l'ordre du temps moyen de relaxation spin-spin des moments magnétiques de particules excitées.

9. Procédé selon l'une quelconques des revendications 1 ou 5, caractérisé en ce que la durée ($T_r$) de chaque séquence est égale ou inférieur à la durée moyenne du temps de relaxation spin-réseau des particules excitées.

## Patentansprüche

1. Schnellverfahren zur Darstellung eines einem starken, d. h. orientierenden magnetischen Feld (B_0) ausgesetzten (1) Körpers (3) mittels Kernspinresonanz in mehreren Sequenzen, in denen:
 – man die magnetischen Momente der Partikel des Körpers mittels einer elektromagnetischen hochfrequenten Anregung anregt (15 bis 17) , um die Orientierung der magnetischen Momente relativ zur Richtung des orientierenden Feldes zu schwenken ($\theta$),

– man das sich aus dieser Anregung ergebende Abregungssignal mittels Gradientimpulsen (13) des magnetischen Feldes codiert (18 bis 25),

– man dieses sich ergebende codierte Signal mißt (7 bis 9),

– und man unter Entcodierung das gemessene Signal verarbeitet (7 bis 11), um aus ihm ein Teilbild des Körpers abzuleiten,

– wobei die Anregung Anregungsimpulse umfaßt, um das Rückstoßen der mit dem orientierenden Feld ausgerichteten Komponenten der magnetischen Momenten der Partikel vor der nachfolgenden Sequenz zu begünstigen, dadurch gekennzeichnet, daß

– die Anregung einen Impuls (15) umfaßt, um die magnetischen Momente durch einen Winkel von deutlich unter 90° zu schwenken, dem eine geradzahlige Anzahl 180°-Spinecho-Annregungsimpulse (16 und 17) folgt.

2. Verfahren nach Anspruch 1, dadurch gekennzeichnet, daß die geradzahlige Anzahl gleich 2 ist.

3. Verfahren nach Anspruch 1 oder 2, dadurch gekennzeichnet, daß der Schwenkwinkel einen Wert zwischen 30° und 60° aufweist.

4. Verfahren nach Anspruch 3, dadurch gekennzeichnet, daß der Schwenlwinkel einen Wert von 45° aufweist.

5. Schnellverfahren zur Darstellung eines einem starken, d. h. orientierenden magnetischen Feld ($B_0$) ausgesetzten (1) Körpers (3) mittels Kernspinresonanz in mehreren Sequenzen, in denen:

– man die magnetischen Momente der Partikel des Körpers mittels einer elektromagnetischen hochfrequenten Anregung anregt (15 bis 17), um die Orientierung der magnetischen Momente in relativ zur Richtung des orientierenden Feldes zu schwenken ($\theta$),

– man das aus sich aus dieser Anregung ergebende Abregungssignal mittels Gradientimpulsen (13) des magnetischen Feldes codiert (18 bis 25),

– man dieses sich ergebende codierte Signal mißt (7 bis 9),

– und man unter Entcodierung das gemessene Signal verarbeitet (7 bis 11), um aus ihm ein Teilbild des Körpers abzuleiten,

– wobei die Anregung Anregungsimpulse umfaßt, um das Rückstoßen der mit dem orientierenden Feld ausgerichteten Komponenten der magnetischen Momenten der Partikel vor der nachfolgenden Sequenz ($T_R$) zu begünstigen, dadurch gekennzeichnet, daß

– die Anregung einen Impuls (15) umßat, um die magnetischen Momente durch einen Winkel von deutlich über 90° zu schwenken, dem eine ungeradzahlige Anzahl 180°-Spinecho-Anregungsimpulse folgt.

6. Verfahren nach Anspruch 1, dadurch gekennzeichnet, daß die geradzahlige Anzahl gleich 2 ist.

7. Verfahren nach Anspruch 3, dadurch gekennzeichnet, daß der Schwenkwinkel eine Wert von 135° aufweist.

8. Verfahren nach Anspruch 1 oder Anspruch 5, dadurch gekennzeichnet, daß die Zeitdauer des gesamten Echos ($T_E$), die durch die Anwendungsdaten der Spinechoimupulse definiert ist, dieselbe Größenordnung hat wie Zeitdauer der Spin-Spin-Entspanung der magnetischen Momente und daß der Schwenkwinkel im wesentlichen 45° ist.

9. Verfahren nach einem der vorhergehenden Ansprüche, dadurch gekennzeichnet, daß die Zeitdauer ($T_r$) jeder Sequenz der durchschnittlichen Zeitdauer der Spin-Gitter-Entspannung der angeregten Partikel entspricht oder diesen Wert unterschreitet.

## Claims

1. Fast imaging process by nuclear magnetic resonance of a body (3) subjected to an intense magnetic field ($B_0$) termed the orientator field, of a type comprising a plurality of the sequences in the course of which:

– excitation (15-17) is applied to the magnetic moments of the particles of the body by means of an electromagnetic radio-frequency excitation in order to tilt ($\theta$) the orientation of these magnetic moments in relation to the direction of the orientator field;

– the de-energization signal resulting from this excitation is coded (18-25) by the aid of impulses of magnetic field gradients (13);

– this coded resultant signal is measured (7-9);

– the measured signal is processed (10-11), decoding it, in order to extract therefrom an image of a part of the body;

– the excitation comprising excitation impulses to assist the growing again of the components aligned with the orientator field of the magnetic moments of the particles before a subsequent sequence ($T_R$), characterized in that

– the excitation comprises an impulse (15) designed to tilt the magnetic moments by an angle well below 90° followed by an even number of excitation impulses (16-17) at 180°, of the type known as spin echo.

2. Process according to Claim 1, characterized in that the even number is 2.

3. Process according to Claim 1 or 2, characterized in that the tilt angle is between 30° and 60°.

4. Process according to Claim 3, characterized in that the tilt angle is substantially equal to 45°.

5. Fast imaging process by nuclear magnetic resonance of a body (3) subjected to an intense magnetic field($B_0$) termed the orientator field, of a type comprising a plurality of the sequences in the course of which:

– excitation (15-17) is applied to the magentic moments of the particles of the body by means of an electromagnetic radio-frequency excitation in order to tilt ($\theta$) the orientation of these magnetic moments in relation to the direction of the orientator field;

– the de-energization signal resulting from this excitation is coded (18-25) by the aid of impulses of magnetic field gradients (13);

– this coded resultant signal is measured (7-9);

– the measured signal is processed (10-11), decoding it, in order to extract therefrom an image of a part of the body;

– the excitation comprising excitation impulses to assist the growing again of the components aligned with the orientator field of the magnetic moments of the particles before a subsequent sequence($T_R$),

characterized in that

– the excitation comprises an impulse (15) designed to tilt the magnetic moments by an angle well above 90°, followed by an odd number of excitation impulses (16-17) at 180°, of the type known as spin echo.

6. Process according to Claim 5, characterized in that the even number is 1.

7. Process according to Claim 5, characterized in that the angle is equal to 135°.

8. Process according to Claim 1 or Claim 5, characterized in that the total echo time($T_E$), defined by the dates of application of the spin echo impulses, is of the order of time of the spin-spin relaxation time of the magnetic moments of particles excited.

9. Process in accordance with either of Claims 1 or 5, characterized in that the duration of ($T_r$) of each sequence is equal to or less than the average spin-network relaxation time of the particles excited.

# FIG_1

$B_0$ →

EP 0 307 433 B1

FIG_2

FIG_3

EP 0 307 433 B1

# FIG_4

EP 0 307 433 B1